(19)

Europäisches
Patentamt

European
Patent Office

Office européen
des brevets

(11) **EP 2 062 857 A1**

(12) **EUROPEAN PATENT APPLICATION**

(43) Date of publication:
**27.05.2009 Bulletin 2009/22**

(21) Application number: **07301562.0**

(22) Date of filing: **21.11.2007**

(51) Int Cl.:
*C01G 15/00* $^{(2006.01)}$     *C01G 17/00* $^{(2006.01)}$

(84) Designated Contracting States:
**AT BE BG CH CY CZ DE DK EE ES FI FR GB GR
HU IE IS IT LI LT LU LV MC MT NL PL PT RO SE
SI SK TR**
Designated Extension States:
**AL BA HR MK RS**

(71) Applicants:
• **Corning SAS
77920 Samois sur Seine (FR)**
• **Ecole Nationale Supérieure d'Ingénieurs de Caen
14050 Caen Cedex 4 (FR)**

(72) Inventors:
• **Nazaraly, Micaela
93150 Le Blan Mesnil (FR)**
• **Berardan, David
14000 Caen (FR)**
• **Guilmeau, Emmanuel Samuel Jérémy
14000 Caen (FR)**
• **Choisnel, Jacques Georges Xavier
14480 Lantheuil (FR)**

(74) Representative: **Boon, Graham Anthony et al
Elkington and Fife LLP,
Prospect House,
8 Pembroke Road
Sevenoaks,
Kent TN13 1XR (GB)**

(54) **Thermoelectric materials comprising a matrix of In2O3 with regions of In2Ge2O7 dispersed therein, thermoelectric elements and methods of making the same**

(57)    A novel thermoelectric material is described which comprises a matrix of $In_2O_3$ with regions of $In_2Ge_2O_7$ dispersed therein. Methods are also described for forming such material. In one such method a particulate material which comprises a mixture of particulate $In_2O_3$ and particulate $CeO_2$ is subjected the mixture to a comminution process, for example by ball milling. In another, a gel is formed and then destabilised to form a particulate material.

**EP 2 062 857 A1**

**Description**

FIELD OF THE INVENTION

This invention relates to thermoelectric materials, thermoelectric elements, and methods of making the same.

BACKGROUND OF THE INVENTION

Roughly a third of the energy consumed by the manufacturing industry is discharged as thermal losses to the atmosphere or to cooling systems. These discharges are the result of process inefficiencies and the inability of the manufacturing plants to utilize the excess energy. A portion of the waste heat is considered to be an opportunity for waste heat recovery, and thermoelectric technologies are being considered to recover and convert the industrial process waste energy to useful electrical energy.

Thermoelectric materials, discovered in 1821, are semiconductor solids that produce an electric current when joined together and subjected to a temperature difference across the junction. Fundamentally, thermoelectricity is concerned with the so-called Seebeck and Peltier effects. The first of these arises because of the property of certain materials, which creates an electrical potential V between the ends of a solid submitted to a thermal gradient $\Delta T$. The Seebeck coefficient (S) represents the Voltage (V) established per $°K$ ($\Delta T$). It is usually expressed in $\mu V/°K$.

$$V = S. \, \Delta T$$

The Seebeck coefficient may be positive (p material) or negative (n material) depending the nature and mobility of the charge carriers in the solid. This property is generally used to collect electrical energy from sources of heat. The Peltier effect is the opposite phenomenon, namely the creation of a temperature gradient in a material submitted to an electrical potential. It is generally exploited in cooling devices. For energy production, several n and p pairs of materials must usually be assembled in series in order to produce enough voltage for the required application.

From the material point of view, the properties required to allow making an efficient thermoelectric generator are:

○ A high Seebeck S absolute value either for p (+) or n (-) material for a significant voltage.
○ A high electrical conductivity $\sigma$, in order to deliver enough intensity.
○ A low thermal conductivity $\kappa$, in order to maintain the thermal gradient at the origin of the voltage obtained.

To express the combination of the requirements on the three previously defined parameters, a figure of merit (FOM) of a material can be expressed in the form of:

$$ZT = \frac{S^2 \sigma}{\lambda} T$$

Where

○ S is the Seebeck coefficient of the material (Volt.Kelvin$^{-1}$)
○ $\sigma$ is the electrical conductivity of the material (Amptro.Volt$^{-1}$,Meter$^{-1}$)
○ $\lambda$ is the thermal conductivity of the material (Watt.Metet$^{-1}$.Kelvin$^{-1}$)

Thermoelectric materials research in the 1950s and 1960s yielded bismuth telluride ($Bi_3Te_3$), lead telluride (PbTe) and silicon-germanium (SiGe) alloys as the materials with the best FOM. $Bi_2Te_3$ and its alloys have been used extensively in thermoelectric refrigeration applications and some niche low-power generation applications.

Although there is no known theoretical limit to Z, and therefore ZT, in practice it has been difficult to achieve high ZT values because of the inherent coupling of electrical conductivity and thermal conductivity in most materials. High electrical conductivity is necessary to minimize resistance (Joule) heating of the thermoelectric device, while low thermal conductivity is needed to maintain a large temperature gradient between the hot side and the cold side. Until about 1990, most researchers focused on semiconductors and metal alloy compounds to develop better thermoelectric materials. This limited material performance in many of the compounds investigated to a ZT of about ~1,

Research from about 1995 to the present has led to the discovery, characterization, and laboratory demonstration of new thermoelectric materials, including skutterudites, clathrates, semi-Heusler compounds, thin-film superlattice materials, quantum well materials, and PbAgSbTe compounds and their derivatives.

At least some of these materials have either demonstrated ZT values of 1 to 1.5, or shown great promise for a higher ZT. Quantum well materials include 0-dimensional (0-D) dots, 1-dimensional (1-D) wires and 2-D thin-film material, and make it possible to create thermoelectric systems that display higher ZT values than those obtained in bulk materials. This is because quantum well effects tend to achieve two important results: firstly, they tend to significantly increase the density of states, which increases the Seebeck coefficient in these materials; and secondly, they tend to decouple the electrical and Thermal conductivity, allowing quantum well materials to exhibit low thermal conductivities without a corresponding decrease in electrical conductivity.

However, all the above known materials have considerable drawbacks regarding their potential use in commercial devices for thermoelectric power generation:

○ Many of them contain toxic or highly toxic elements like tellurium, bismuth or antimony, with among them elements for which use is or may be restricted or forbidden in the European Union and elsewhere.

○ None of them are stable in air with respect to oxidation or vaporisation, and thus they have to be used in encapsulated devices, which imply high industrial costs.

○ All except SiGe-based alloys exhibit transport properties which vary rapidly with varying temperature. For example, $Bi_2Te_3$ based alloys exhibit high ZT values around 100°C, but these values fall very rapidly below 50°C and above 150°C.

Consequently, these materials can only be used over short temperature ranges, and are therefore not good candidates for power generation with high temperature gradients. Furthermore, they are difficult to synthesize on an industrial scale. Due to these important drawbacks, the commercial use of thermoelectric devices needs a new type of thermoelectric material.

Compared to semiconductors usually used for thermoelectric applications, oxides are considered to be promising for future thermoelectric applications. They have many advantages such as nontoxicity, thermal stability (when they are in their classical and stable oxidation state), and high corrosion resistance, Electrical transport properties in oxides have been studied following the discovery of $Na_xCoO_2$ by Terasaki et al. (see Terasaki, Sasago, Uchinokura, Large thermoelectric power in NaCoO2 single crystals, Phys. Rev. B, 56, R12685, 1997 and Yakabe, Kikuchi, Terasaki, Sasago, Uchinokura, Thermoelectric properties of transition metal oxides NaCo2O4 system, pp 523-527. Proceedings of the 16th International Conference on Thermoelectrics, Dresden, Germany, 1997). Since then, oxides have become potential thermoelectric candidates. Cobalt-oxide-based layered structured crystals ($Na_xCoO_2$ - $Ca_3Co_4O_9$ and their derivatives) have been developed as p-type thermoelectric materials. (see Funahashi et al., An oxide single crystal with high thermoelectric performance in air, Jpn. J. Appl. Phys., 39, L1127, 2000 and Ohtaki et al., Improved thermoelectric performance of sintered NaCo2O4 with enhanced 2-dimensional microstructure, p190-195, Proceedings of the 19th International Conference on Thermoelectrics, 2000). In contrast, n-type materials proposed so far exhibit lower figures of merit. They remain to be further explored and novel oxides families for n-type materials have to be studied.

Other potential oxide families for thermoelectric power generation include $LaCoO_3$ and $InBaCo_2O_{5+8}$, manganites, orthochromites, ZnO and $SrTiO_3$. However, at present, no oxide exhibits thermoelectric properties which are good enough to be used in an efficient commercial device.

One family of materials which may have potential for use as thermoelectric materials, are transparent conducting oxides (TCOs). These have been known and employed technologically in other applications, though not as thermoelectric materials, for more than 50 years. For example, ITO (indium tin oxides), have been developed as TCOs for display applications. The favourable rale of the $d^{10}$ cations ($Zn^{2+}$, $Cd^{2+}$, $Sn^{4+}$, $Ga^{3+}$) to create both conductivity and transparency in oxides has been repeatedly confirmed. In this respect, the antimony doped indium oxide (IAO) obtained from a mixture of $In_2O_3$ and $Sb_2O_3$ has been proposed. All these oxides exhibit a low resistivity, but in spite of that have not been explored for thermoelectric applications. For the purpose of generating new TCOs, the synthesis of bixbyite oxides, where trivalent cations are partially replaced by divalent and tetravalent cations, has been studied in the past From this point of view, the co-substituted Zn/Sn-$In_2O_3$ TCOs discovered by Palmer et al. are of interest (G. B. Palmer, K. R. Poeppelmeier, T. O. Mason, Chem. Mater 9 (1997) 3121)). Some properties (conductivity, carrier concentration and mobility, magnetic measurements and thermopower) have been reported ((a) A. Ambrasini, G. B. Palmer, A. Maignan, K. R. Pocppelmeier, M. A. Lane, P. Brazis, C. R. Kannewurf, T. Hogan, T. O. Mason, Chem. Mater. 14 (2002) 52, (b) G. B. Palmer, K. R. Poeppelmeier, T. O. Mason, Chem. Mater, 9 (1997) 3121, (c)) G. B. Palmer, K. R. Poeppelmeier, T. O. Mason JSSC 134 (1997) 192). In order to understand the influence of the electronic structure of the divalent cation upon the properties, the investigation of the substitution of the couple $Sn^{4+}/M^{2+}$ for $In^{3+}$ has been carried out, with $M^{2+}$ = $Cu^{2+}$, $Ni^{2+}$, $Mg^{2+}$, $Ca^{2+}$ (A.F. Ioffe, Semiconductor Thermoelements and Thermoelectric Cooling Infosearch, London, (1957) The substituted compositions, $In_{2-2x}M_xSn_xO_3$, were prepared by solid state reaction of powder mixtures of pure

$In_2O_3$, $SnO_2$ and MO oxides (M=Zn, Cu, Ni, Mg). The coupled substitution in $In_2O_3$) with $Cu^{2+}/Sn^{4+}$ and $Zn^{2+}/Sn^{4+}$ was found to enhance the conductivity.

The electrical conductivity in ITO is strongly dependent on the dopant. Even if the conductivity of the ITO and the series $In_{2-2x}Sn_xM_xO_3$ is high, it could be increased by the partial or total substitution of $Sn^{4+}$ by another doping element. It has been established by Campet et al (G. Campet, S. D. Han, S. J. Wen, M. C. R. Shastry, B. Chaminade, E. Marquestaut, J. Portier, P. Dordor, Material Science and Engineering B22 (1994) 274) that the substitution by $Ge^{4+}$ could give good results (($GeC_2/In_2O_3$ ratios varied from 0.00125 to 0.025 and confirmed by Hakam et al (A. Hakam, L. Ouboumalk, M. Banouq, Y. Saidi, M. Taibi, J. Aride, Ann. Chim. Sci. Mat. (2000) 25) ($GeO_2/In_2O_3$ ratios varied from 0 to 0.05). These studies showed that indium based oxides exhibit a higher conductivity and higher electronic mobility when they are doped with $Ge^{4+}$.

## SUMMARY OF THE INVENTION

The present invention is based on the discovery of novel germanium-doped indium oxide materials, in which a hitherto unobserved new phase, $In_2Ge_2O_7$, is present. Without wishing to be bound by this theory, it is presently believed that the presence of this second phase impedes phonon propagation in the lattice and thereby decreases the conduction of heat.

According to the present invention there is provided a thermoelectric material comprising a matrix of $In_2O_3$ with regions of $In_2Ge_2O_7$ dispersed therein. Preferably, the amount of Ge therein represents at least 0.02 wt% based on the combined weight of $In_2O_3$, and may represent at least 2 wt%. The amount of Ge may, for example, represent up to 10 wt%. In the description below the composition of the thermoelectric material is expressed in the form $In_{2-x}Ge_xO_3$, but it is to be understood that this is merely intended as convenient shorthand to express the relative amounts of In, Ge and O in the composition, and that the actual material is substantially, and at least to the limits of detection of analysis equipment employed, the two-phase material just defined.

The invention further provides, in one aspect thereof, a method of forming a thermoelectric material which comprises selecting a particulate material which consists of a mixture of particulate $In_2O_3$ and particulate $GeO_2$, and subjecting the mixture to a comminution process in which energy is imparted to the mixture, to form a comminuted material. The comminution process is preferably a ball milling process.

In another aspect the invention provides a method of forming a thermoelectric material which comprises forming a gel having $In^{3+}$, $Ge^{4+}$ and $O^{2-}$ ions, and destabilising the gel to form a particulate material. The destabilisation is preferably effected by heating. By way of example, a specific method is described below in which the gel is formed using $In(NO_3)_3$, $GeCl_4$ and citrie acid.

In both cases, the final solid state elements are obtained by pressing and sintering the above described particulate materials. It has found that solid state elements made according to the invention are stable at high temperature and exhibit a good figure of merit as n-type materials, over a temperature range wide enough to make them good candidates for thermoelectric generators above 600°C.

## EXAMPLES

### Example 1

$In_{1.9}Ge_{0.1}O_3$ was synthesized by mixing 4.809 g of $In_2O_3$ and 0,191 g of $GeO_2$ (i.e. 3.8 wt% Ge, based on the total weight of powder) in a ball mill (jar volume: 80 ml) for 30 minutes using an agate vial and six agate balls (three balls have a diameter of 1 cm and the three other balls have a diameter of 2 cm) at a rotation speed of 550 rpm. The ball milling step leads to a strong decrease of the particle size of the precursor materials. It also leads, as will be explained below to the formation of a new phase in the material.

The powder mixture thus produced was simultaneously reacted and densified using the following process:

(i) Portions of the material were pressed uniaxially to form parallelepipedic bars (~2x3x12 mm$^3$), under a pressure of 3 tons-wt per cm$^2$, Rodoviol® was used as a binder, or densifiication additive. (Rodoviol® is available from VWR International S.A.S., Fontenay-sous-Bois, France, and is polyvinyl alcohol).

(ii) The bars thus obtained were slowly heated in air on platinum foils in an alumina crucible at a temperature which increased from room temperature to 500°C at a rate of 20°C per hour, in order to eliminate the binder without inducing cracks.

(iii) The bars were then heated from 500°C to the sintering temperature (1300 or 1350°C), the temperature increasing at a rate of 100°C per hour, and then held at the sintering temperature for 24 hours.

(iv) The bars were slowly cooled down to room temperature at a rate of 50°C per hour.

Example 2

The method described above was repeated for various other mixtures of $In_2O_3$ and $GeO_2$, in each of which the total mass of powder was 5g, but in which the relative proportions varied. The proportions used can be seen in Table 1.

Table 1

| x | Compound | m(g) $GeO_2$ | m(g) $In_2O_3$ | Resulting %wt Ge |
|---|---|---|---|---|
| 0.002 | $In_{1.998}Ge_{0.002}O_3$ | 0,0037 | 4,9963 | 0,026 |
| 0.004 | $In_{1.996}Ge_{0.004}O_3$ | 0,0075 | 4,9925 | 0,105 |
| 0.006 | $In_{1.994}Ge_{0.006}O_3$ | 0,0112 | 4.9888 | 0,157 |
| 0.01 | $In_{1.99}Ge_{0.01}O_3$ | 0,019 | 4,9981 | 0,262 |
| 0.015 | $In_{1.995}Ge_{0.015}O_3$ | 0,0282 | 4,9718 | 0,393 |
| 0.02 | $In_{1.98}Ge_{0.02}O_3$ | 0,0376 | 4,9624 | 0,525 |
| 0.04 | $In_{1.98}Ge_{0.04}O_3$ | 0,0753 | 4,9247 | 1,052 |
| 0.06 | $In_{1.94}Ge_{0.06}O_3$ | 0,1133 | 4,8867 | 1.583 |
| 0.08 | $In_{1.92}Ge_{0.08}O_3$ | 0,1514 | 4,8486 | 2,117 |
| 0.1 | $In_{1.9}Ge_{0.1}O_3$ | 0,19 | 4,81 | 2,655 |
| 0.2 | $In_{1.8}Ge_{0.2}O_3$ | 0,3843 | 4,6157 | 5,393 |
| 0.3 | $In_{1.7}Ge_{0.3}O_3$ | 0,584 | 4.416 | 8,219 |

Example 3

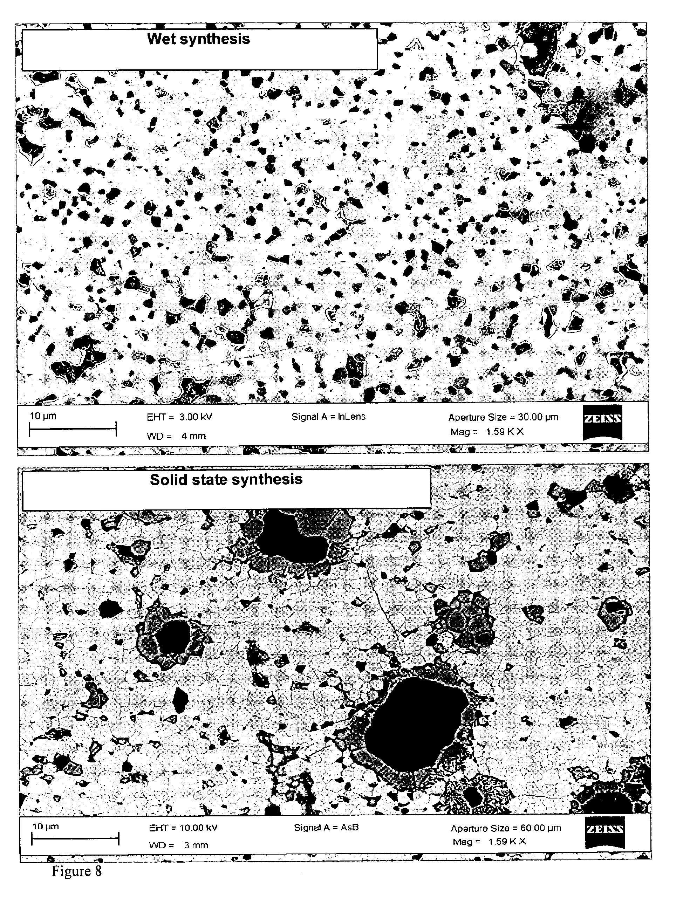

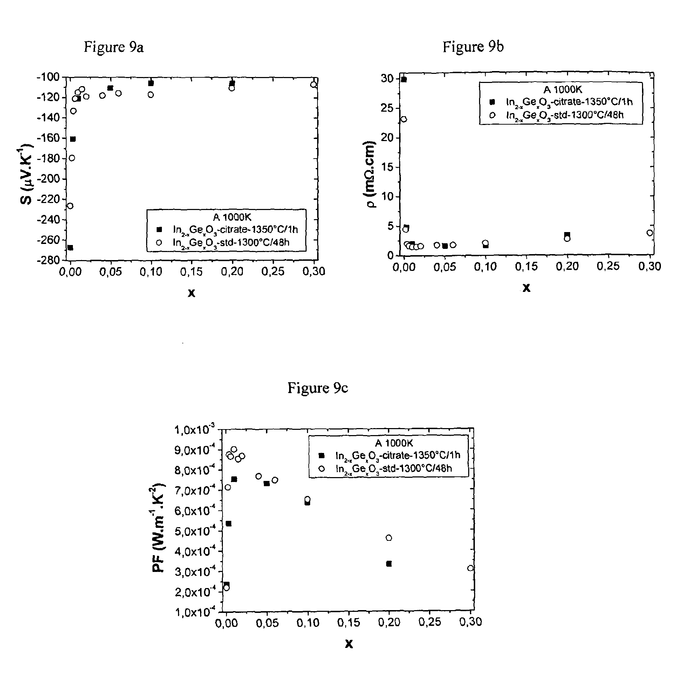

In this example the thermoelectric material according to the invention was made using aqueous synthesis. In this, water (3 $dm^3$) was added to 25g of $GeCl_4$ to cause it to hydrolyze and the resulting solution was heated to evaporate the water and leave bexagonal-form-$GeO_2$. This material is soluble in water. Indium(III) nitrate, hexagonal $GeO_2$ and citric acid were added in stoichiometric proportion to one another and heated at 100°C for several hours until they formed a gel. As an example, in $In_{1.8}Ge_{0.2}O_3$, the In : Ge : citric acid ratio is 1.9: 0.1 : 2 and 12.34 ml of $In(NO_3)_3.H_2O$, 0.0433g of $GeO_2$ and 0.7402g of citric acid are needed. The obtained gel was then heated at 600°C for 1 hour to form a finely particulate material. Steps (i) and (ii) of Example 1 were then carried out, except that the sintering in step (ii) was carried out at 1350°C for one hour. As in the case of the material formed by the method of the preceding examples, the presence of the secondary phase $In_2Ge_2O_7$ can be detected in the same way here. It is in fact observed that this wet chemistry process leads to a more homogenous distribution of the secondary phase $In_2Ge_2O_7$ in the matrix, compared to the dry state synthesis (Figures 8). It is believed that this homogencity may be advantageous for the thermoelectric properties, parlicularly on thermal conductivity. Figures 9a, 9b and 9c show that Seebeck coefficient, the electrical resistivity and the power factor for materials obtained by the citrate method and the solid state chemistry method are comparable. Without being bound by this theory, it is thought that a homogeneous distribution of particles may improve the ability of the material to diffuse the phonons and thus decrease the thermal conduction.

BRIEF DESCRIPTION OF THE DRAWINGS AND FIGURES

Figure 1 - Portion of an X-ray diffraction graph for an example ($In_{1.9}Ge_{0.1}O_3$) of thermoelectric material according to the invention just after the ball-milling comminution step, exhibiting second phase ($In_2Ge_2O_7$) occurrence.

Figure 2 - Rietveld refinement of the whole X-ray diffraction graph of the example featured in Figure 1;

Figure 3 - Scanning Electron Micrograph of the material corresponding to Figures 1 and 2;

Figure 4a, 4b, 4c - Plot of the electrical resistivity (a), of the Seebeck coefficient (b) and resulting power factor (c) versus temperature, for the example of Figures 1 to 3;

Figure 5 Influence of the germanium content (x in the formula $In_{2-x}Ge_xO_3$) on electrical resistivity (filled symbols) and thermopower (open symbols) at 1000˚K, for materials produced using ball milling;

Figure 6 - Thermal conductivity $\lambda$ as a function of the quantity x of germanium, for various temperatures for materials synthesized according to the invention.

Figure 7 - Values of figure of merit ZT at different temperatures and different values of x.

Figure 8 - Comparative Scanning Electron Microscope pictures of solids obtained after a wet synthesis and the solid state chemistry,

Figure 9a-9b and 9c - Seebeck coefficient, electrical resistivity and resulting power factor for materials obtained by the citrate method and the solid state chemistry, for different values of x.

## CHARACTERIZATION OF THE MATERIALS OF THE INVENTION

The materials were characterized by X-ray powder diffraction (XRD), using Rietveld refinement and Scanning Electron Microscopy.

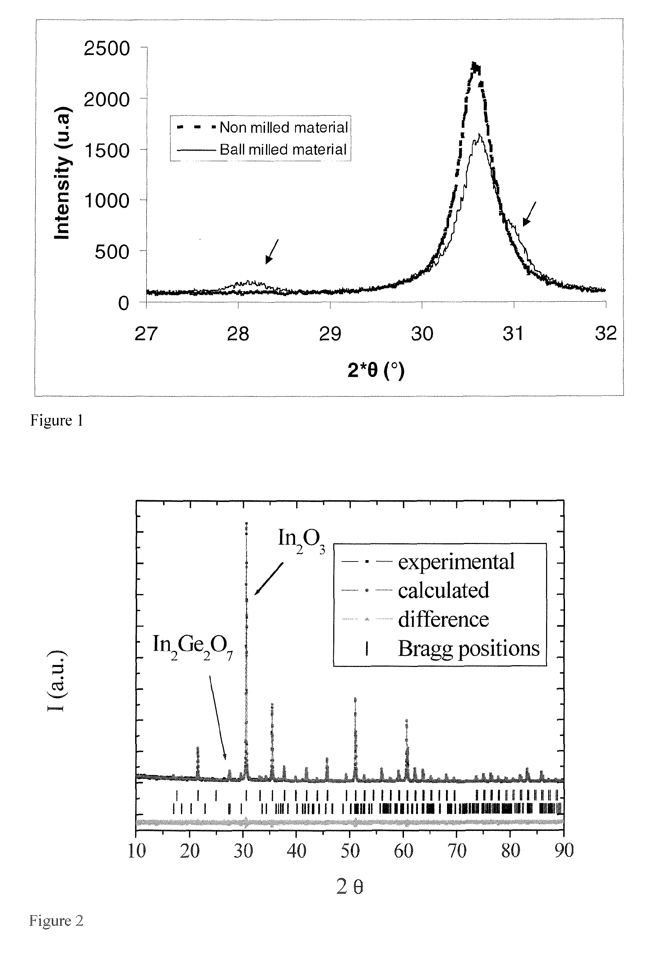

Figure 1 shows part of an XRD graph derived from a sample with nominal composition $In_{1.9}Ge_{0.1}O_3$. The dotted lines in these figures show the XRD graph obtained before ball millings and the solid lines show the graph obtained after milling. It will be apparent that there are significant differences between the two lines in the regions pointed by an arrow.

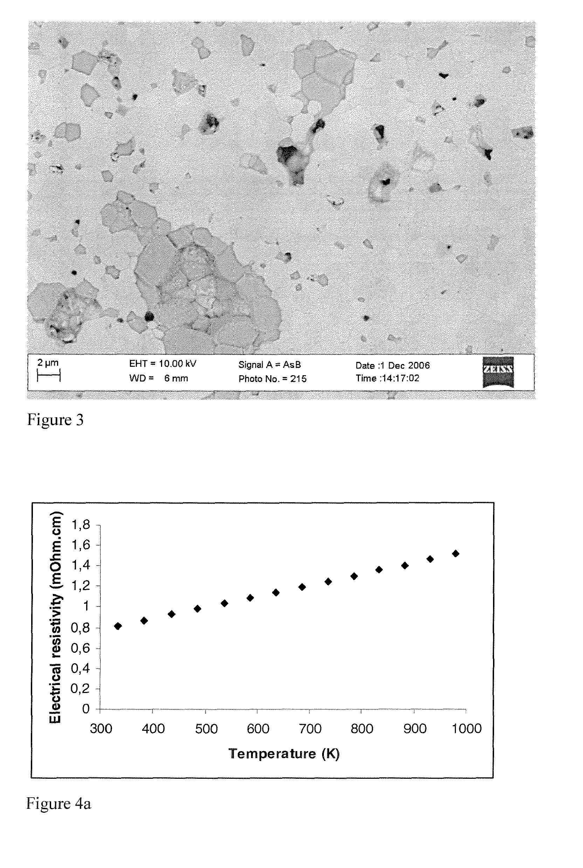

Figure 2 shows the Rietveld refinement for the whole of the graph of which Figure 1 is a part. All Bragg peaks can be indexed on the basis that what is present is a mixture of $In_2O_3$ as main phase and $Tn_2Ge_2O_7$ as secondary phase. This result is confirmed by SEM observations (Figure 3) coupled to EDX spectroscopic analysis. This shows the presence of $In_2Ge_2O_7$ inclusions as secondary phases (dark grains) and the absence of germanium in the main phase within the detection limit of EDX spectroscopy. Thus, as already mentioned, $In_{2-x}Ge_xO_3$ is used herein as a shorthand to refer to what is in fact a composite material constituted of an $In_2O_3$ phase with $In_2Ge_2O_7$ inclusions.

## PROPERTIES OF THE MATERIALS OF THE INTENTION

The electrical conductivity and thermopower were measured simultaneously using a ULVAC-ZEM3 device between 50˚C and 800˚C under helium. The thermal conductivity was obtained at 26˚C, 500˚C and 1000˚C from the product of the geometrical density, the heat capacity and the thermal diffusivity from a Netzsch model 457 MicroFlash laser flash apparatus.

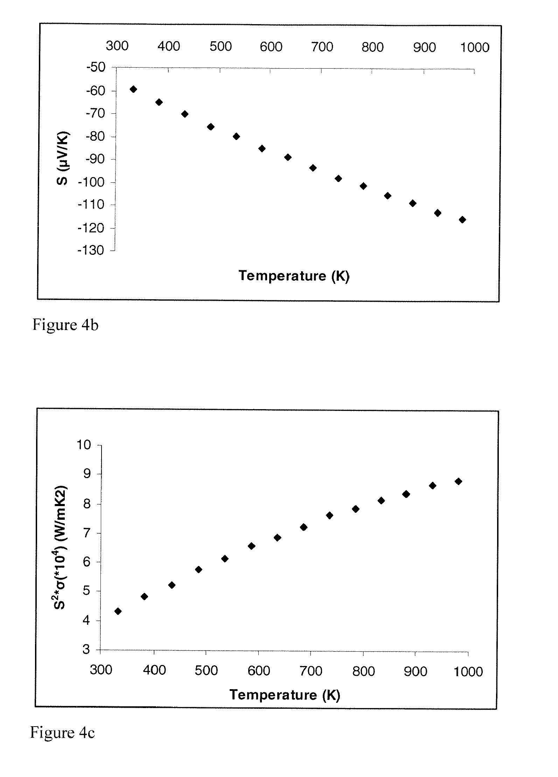

All samples with x>0 are n-type and have a metallic behaviour with the electrical resistivity, the absolute value of the thermopower and power factor increasing with temperature, as it is exemplified in Figures 4a, 4b, 4c for x= 0.1.

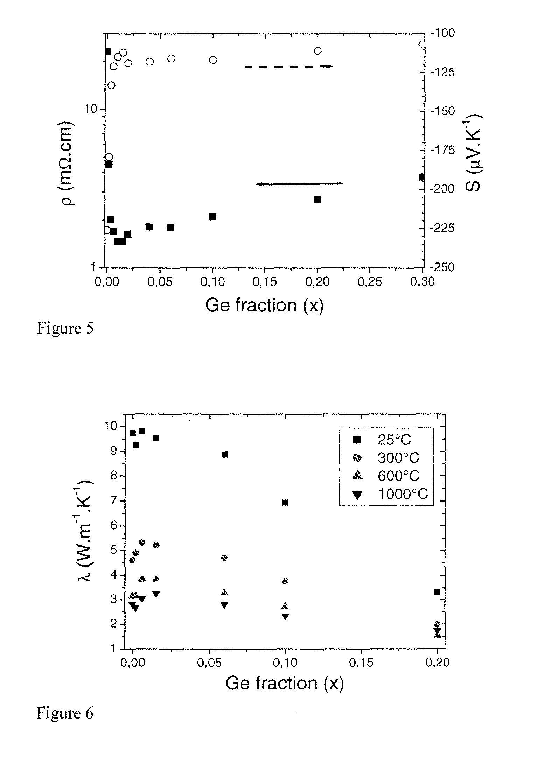

Figure 5 shows the influence of germanium content on the electrical resistivity and thermopower. Starting from undoped $In_2O_3$ with $\rho$~25 m$\Omega$.cm at 1000K, a very small addition of germanium, of the order 0.1 atom% (x=0.002), leads to a strong decrease of the electrical resistivity, by a factor of 5. Further additions lead to a decrease of the resistivity with a minimum reached at x=0.015 with $\rho$~1.5 m$\Omega$.cm.

The behaviour of the thermopower is similar. Starting from undoped $In_2O_3$ with S ~ -225 $\mu$V.K$^{-1}$ at 1000K, a very small addition of germanium leads to a decrease of the thermopower, which is constant with S ~ -110 $\mu$V.K$^{-1}$ when the germanium fraction exceeds x=0.015.

Figure 4c shows, for a material ($In_{1.9}Ge_{0.1}O_3$) produced by ball milling, the temperature dependence of the power factor $S^2\sigma$ calculated using the measured electrical resistivity and thermopower. The power factor PF increases with increasing temperature in the whole temperature range for all samples. It thus appears that Ge doping is very efficient to enhance the thermoelectric properties at high temperature. Starting from undoped $In_2O_3$ with PF ~ $2.2.10^{-4}$ W.m$^{-1}$.K$^{-1}$, a very small addition of germanium, of the order x=0.002-0.006, to a strong increase of the power factor, by a factor of approximately 4.

The thermophysical properties (thermal diffusivity, specific heat and bulk density) of these samples were measured, and were used to compute the thermal conductivity by the following equation:

$$\lambda = \rho \cdot c_p \cdot a$$

With

$\lambda$ : Thermal Conductivity
$\rho$ : Bulk Density
$c_p$ : Specific Heat
a : Thermal Diffusivity

The thermal diffusivity and specific heat were measured using a NETZSCH model 457 *MicroFlash*™ laser flash diffusivity apparatus. The measurements were conducted in a dynamic argon atmosphere at a flow rate of ≈1 100 ml/min between 25°C and 1000°C. The samples had a thickness of approx. 2.5 mm, A standard sample holder was used for the tests.

Figure 6 describes the influence of the germanium fraction on the thermal conductivity. For each measured temperature, a maximum for the value of $\lambda$ is clearly observable when x ranges between 0.006 and 0.015.

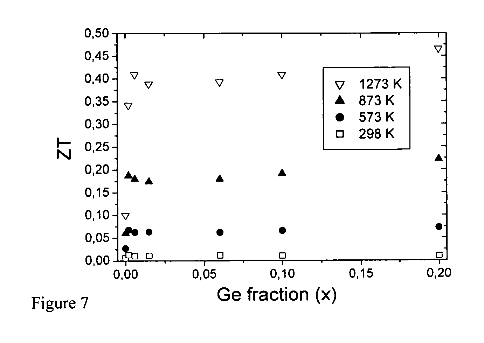

The plot of ZT versus the Ge fraction (Figure 7) for different temperatures shows the effect of the secondary phases on the thermoelectric figure of merit. The ZT values reach a first maximum at a value for x in the region of 0.015 (clearly observable for 1273°K), and subsequently increase slowly with increasing Ge content to reach 0.45 at 1273°K for the composition $In_{1.8}Ge_{0.2}O_3$.

The results displayed in Figures 4 to 7 lead to Table 2 below which dispatches some resulting dimensionless of merit (ZT) as a function of temperature, relating to the materials described for different values of x when the overall formulation is epressed as $In_{2-x}Ge_xO_3$.

Table 2

|  | ZT at 298K | ZT at 573K | ZT at 873K | ZT at 1273K |
|---|---|---|---|---|
| x=0 | 0,00574 | 0,02667 | 0,05968 | 0,10012 |
| x=0.002 | 0,01223 | 0,06755 | 0,18768 | 0,34201 |
| x=0.006 | 0,01015 | 0,06249 | 0,18008 | 0,40931 |
| x=0.015 | 0,01085 | 0,06291 | 0,17423 | 0,38856 |
| x=0.06 | 0,01139 | 0,06181 | 0,17982 | 0,3931 |
| x=0.01 | 0,01037 | 0,06574 | 0,19135 | 0,40942 |
| x=0.02 | 0,00939 | 0,07192 | 0,22242 | 0,46554 |

**Claims**

1. A thermoelectric material comprising a matrix of $In_2O_3$ with regions of $In_2Ge_2O_7$ dispersed therein.

2. A material according to claim 1, wherein the amount of Ge therein represents at least 0.02 wt%. based on the total weight of the material.

3. A material according to claim 1, wherein the amount of Ge therein represents at least 2 wt%, based on the total weight of the material.

4. A material according to any preceding claim, wherein the amount of Ge therein represents up to 10 wet%, based on the total weight of the material.

5. A method of forming a thermoelectric material which comprises:

   (a) selecting a particulate material which consists of a mixture of particulate $In_2O_3$ and particulate $GeO_2$, and
   (b) subjecting the mixture to a comminution process in which energy is imparted to the mixture, to form a comminuted material.

6. A method according to claim 5, wherein the said selected particulate material is dry particulate material, and the method of forming the comminuted material is a dry process.

7. A method according to claim 6, wherein the comminution process is a ball milling process.

8. A method of forming a thermoelectric material according to claim 1 wherein a particulate material is formed in a wet state.

9. A method of forming a thermoelectric material which comprises forming an aqueous gel having $In^{3+}$, $Ce^{4+}$ and $O^{2-}$ ions, and destabilising the gel to form a particulate material.

10. A method according to claim 9, wherein destabilising is effected by heating.

11. A method according to claim 9 or 10, wherein the $In^{3+}$ ions arc provided in the form of indium nitrate.

12. A method according to any one of claims 9 to 11, wherein the $Ge^{4+}$ ions are provided in the form of $GaCl_4$.

13. A method according to any one of claims 9 to 12, wherein destabilisation is effected by the addition of citric acid.

14. A method of forming a thermoelectric element which comprises:

(c) comprising the comminuted material of any one of claims 5 to 7, or the particulate material of any one of claims 8 to 13, into an element precursor having the shape desired for the element: and
(d) heating the element precursor to cause it to sinter and thereby form the said Thermoelectric element.

Figure 1

Figure 2

Figure 3

Figure 4a

Figure 4b

Figure 4c

Figure 5

Figure 6

Figure 7

Figure 8

Figure 9a

Figure 9b

Figure 9c

**European Patent Office**

**EUROPEAN SEARCH REPORT**

Application Number

EP 07 30 1562

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DATABASE CA [Online] CHEMICAL ABSTRACTS SERVICE, COLUMBUS, OHIO, US; SARKISOV, E. S. ET AL: "Indium pyrogermanate" XP002477145 retrieved from STN Database accession no. 69:70425 * abstract * & IZVESTIYA AKADEMII NAUK SSSR, NEORGANICHESKIE MATERIALY , 4(3), 473-4 CODEN: IVNMAW; ISSN: 0002-337X, 1968, ----- | 1-4 | INV. C01G15/00 C01G17/00 |
| X | CAMPET, G.; HAN, S. D.; WEN, S. J.; MANAUD, J. P.; PORTIER, J.; XU, Y.; SALARDENNE, J.: "The electronic effect of titanium(4+), zirconium(4+) and germanium(4+) dopings upon the physical properties of indium(III) oxide and tin-doped indium(III) oxide ceramics: application to new highly-transparent conductive electrodes" MATERIALS SCIENCE & ENGINEERING, vol. B19, no. 3, 1993, pages 285-289, XP002477144 * page 286, paragraph 2.1.; table 1 * ----- | 5,14 | |
| Y | DATABASE CA [Online] CHEMICAL ABSTRACTS SERVICE, COLUMBUS, OHIO, US; SARKISOV, E. S. ET AL: "Indium pyrogermanate" XP002477146 retrieved from STN Database accession no. 74:103611 * abstract * -/-- | 9-13 | TECHNICAL FIELDS SEARCHED (IPC) C01G H01L |

The present search report has been drawn up for all claims

| Place of search | Date of completion of the search | Examiner |
|---|---|---|
| The Hague | 18 April 2008 | Siebel, Eric |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## EUROPEAN SEARCH REPORT

Application Number

EP 07 30 1562

**European Patent Office**

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| | & IZVESTIYA AKADEMII NAUK SSSR, NEORGANICHESKIE MATERIALY , 7(2), 341-2 CODEN: IVNMAW; ISSN: 0002-337X, 1971, ----- | | |
| Y | DATABASE CA [Online] CHEMICAL ABSTRACTS SERVICE, COLUMBUS, OHIO, US; ZHANG, JIANRONG ET AL: "Method for preparing indium tin oxide powder with high sintering activity" XP002477147 retrieved from STN Database accession no. 147:145782 * abstract * & CN 1 978 323 A (EAST CHINA UNIVERSITY OF SCIENCE AND TECHNOLOGY, PEOP. REP. CHINA) 13 June 2007 (2007-06-13) ----- | 9-13 | |

**TECHNICAL FIELDS SEARCHED (IPC)**

The present search report has been drawn up for all claims

| Place of search | Date of completion of the search | Examiner |
|---|---|---|
| The Hague | 18 April 2008 | Siebel, Eric |

EPO FORM 1503 03.82 (P04C01)

**ANNEX TO THE EUROPEAN SEARCH REPORT
ON EUROPEAN PATENT APPLICATION NO.**

EP 07 30 1562

This annex lists the patent family members relating to the patent documents cited in the above-mentioned European search report.
The members are as contained in the European Patent Office EDP file on
The European Patent Office is in no way liable for these particulars which are merely given for the purpose of information.

18-04-2008

| Patent document cited in search report | Publication date | Patent family member(s) | Publication date |
|---|---|---|---|
| CN 1978323 A | 13-06-2007 | NONE | |

EPO FORM P0459

For more details about this annex : see Official Journal of the European Patent Office, No. 12/82

**EP 2 062 857 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **TERASAKI ; SASAGO.** Uchinokura, Large thermo-electric power in NaCoO2 single crystals. *Phys. Rev. B,* 1997, vol. 56, R12685
- **YAKABE ; KIKUCHI ; TERASAKI ; SASAGO ; UCHINOKURA.** Thermoelectric properties of transition metal oxides NaCo2O4 system. *Proceedings of the 16th International Conference on Thermoelectrics,* 1997, 523-527
- **FUNAHASHI et al.** An oxide single crystal with high thermoelectric performance in air. *Jpn. J. Appl. Phys.,* 2000, vol. 39, L1127
- **OHTAKI et al.** Improved thermoelectric performance of sintered NaCo2O4 with enhanced 2-dimensional microstructure. *Proceedings of the 19th International Conference on Thermoelectrics,* 2000, 190-195
- **G. B. PALMER ; K. R. POEPPELMEIER ; T. O. MASON.** *Chem. Mater,* 1997, vol. 9, 3121

- **A. AMBRASINI ; G. B. PALMER ; A. MAIGNAN ; K. R. POCPPELMEIER ; M. A. LANE ; P. BRAZIS ; C. R. KANNEWURF ; T. HOGAN ; T. O. MASON.** *Chem. Mater.,* 2002, vol. 14, 52
- **G. B. PALMER ; K. R. POEPPELMEIER ; T. O. MASON.** *JSSC,* 1997, vol. 134, 192
- **A.F. IOFFE.** *Semiconductor Thermoelements and Thermoelectric Cooling Infosearch,* 1957
- **G. CAMPET ; S. D. HAN ; S. J. WEN ; M. C. R. SHASTRY ; B. CHAMINADE ; E. MARQUESTAUT ; J. PORTIER ; P. DORDOR.** *Material Science and Engineering,* 1994, vol. B22, 274
- **A. HAKAM ; L. OUBOUMALK ; M. BANOUQ ; Y. SAIDI ; M. TAIBI ; J. ARIDE.** *Ann. Chim. Sci. Mat.,* 2000, 25

19